# EUROPEAN PATENT APPLICATION

(11) **EP 3 211 571 A1**
(43) Date of publication of application: **30.08.2017**
(21) Application number: 17157447.8
(22) Date of filing: 22.02.2017
(51) Int. Cl.: G06Q 10/00, G06Q 10/10, G06Q 10/08

(54) **SYSTEM AND METHOD FOR OPTIMIZATION OF RECOMMENDED SERVICE INTERVALS**

(30) Priority: 24.02.2016 US 201615052536
(71) Applicant: General Electric Company, Schenectady, NY 12345 (US)
(72) Inventor: KEMP, JR., Preston Butler, Greenville, SC South Carolina 29615 (US)
(74) Representative: Pöpper, Evamaria

(57) **Abstract**

A method for determining a recommended maintenance interval for each of a plurality of units within a fleet of power generation units, including: collecting empirical data representing operational and unplanned maintenance data for a plurality of units (208, 211) within a fleet of power generation units; evaluating the empirical data of the operational and unplanned maintenance data; generating (101) a plurality of failure mode models based on the empirical data; combining (102) the plurality of failure mode models; establishing (103, 104) a target operational metric for the combination of the plurality of failure mode models; generating (202, 302) a fleet recommended maintenance interval for the fleet of power generation units based on the target operational metric; calculating (208) an operational profile for each of the plurality of units within the fleet of power generation units; calculating (108, 109, 210) the recommended maintenance interval for each of the plurality of units within the fleet of power generation units based on the operational profile of each unit.

## Description

### BACKGROUND OF INVENTION

The invention relates to determining recommended maintenance intervals and particularly maintenance intervals for a fleet of units based on the operational profile of each unit.

Power generation units, such as the units responsible for creating electrical power for utility companies, are regularly tasked with operating continuously for extended periods at high levels. The units need to be considered to have a high level of reliability. Maintaining reliability under these requirements may be difficult since the components of power generation units are prone to deterioration with use, which may include wear, fatigue, cracking, oxidation, and other damage, and require regular maintenance. Deterioration that can lead to failure of a unit may be referred to as a failure mode.

Power generation units generally include large components, many of which rotate in use and operate under extreme conditions, and are also subjected to large mechanical and electrical loads. Without proper maintenance, these units may degrade due to wear and will ultimately fail if not properly maintained. To avoid failure, the power generation units are taken off-line for periodic repair and maintenance under a regular schedule.

Scheduling maintenance and repair of power generation units often includes setting an operational period during which a unit is continuously operated, the operational period lasting from a first event which takes the unit off-line for repair and/or maintenance until a second event which also takes the unit off-line for repair and/or maintenance. Determining the length of the operational period usually involves balancing the requirement for reliable operation of the unit and a need for continuous and extended operation.

To perform repair and/or maintenance work on a power generation unit, the unit must be taken off-line. While off-line, the unit is not generating power for a power grid. If the operational period is allowed to be too long, the power unit may unexpectedly fail during operation. Such unexpected failure results in an unplanned outage of power generation, which reduces power output of a plant relying on the unit and may have a high cost in both monetary and human capital due to the suddenness and immediacy of the need for repair. On the other hand, shortening the operational period reduces the amount of time during which the unit is generating power between repair and maintenance events and therefore reduces the total amount of power generated by the unit over an extended period such as the life of the power generation unit due to the more frequent off-line sessions. Another way to describe taking a unit offline is reducing "availability," which may be described mathematically. Mathematically, "1" represents being available for an entire calendar year, which is 365 days. "0" would represent a unit which is offline for an entire year and is thus available for 0 days out of a year. To mathematically represent when a particular unit is available, a calculation may be made in the form of (1-(total downtime divided by total calendar time)), where total downtime is the sum of planned and unplanned downtime. Conventionally, a calculated likelihood of failure is used to determine an appropriate operational period for an industrial power generation unit that extends between planned off-line maintenance and repair events. The calculated likelihood of failure is then used to balance the requirement of maintaining a reliable power unit with the need for generated power.

The calculated likelihood of failure may be characterized as a likelihood of the power generation unit suffering an unplanned outage. A power unit suffers an unplanned outage when the unit is taken off-line at a time other than a scheduled off-line period. The unplanned outage is typically due to a failure of a power generation unit operating in the field such as in a power generation plant.

Unplanned outage likelihood is traditionally determined based on historical data of actual field failures of power generation units. Actual field failures are useful for estimating the likelihood of failure, but do not accurately account for all potential failure modes of the power generation unit. Some failure modes are not reflected in the historical failures of units.

To model these other failure modes, a "lurking model" has conventionally been used. For example, the likelihood of previously unseen failure modes may be estimated using the lurking model. The lurking model approach is crude and is based on a hypothetical analysis of unforeseen and unseen modes of failures. A lurking model takes into account the likelihood associated with those unknown failure mode(s) of the system or system components which may occur in the future if the system or component is allowed to operate beyond the current operating experience. It is usually estimated using a Weibayes model, which is a type of Weibull model with no failure points, and in which a shape parameter (also known as "beta") is assumed. A value of beta may be relatively high and may be in the range of 3 to 4. Generally, beta may be in the range of 1 to 4. The hypothetical analysis used in the lurking model may not anticipate actual unforeseen failure modes of a power generation unit.

Conventionally, maximum intervals of operation may also be based on either the maximum amount of hours of operation or a maximum number of starts of a particular unit. The use of a maximum interval for hours or a maximum interval for starts results in an operational metric varying as a function of the operational profile of a specific unit in the fleet. The further a specific unit is from the maximum hours or starts limit, the less optimally it is being serviced. In other words, the unit could be operated for more hours or cycles than is allotted under current recommendations.

Therefore, at a fleet level, units are being prematurely serviced due to conventionally recommended maintenance intervals. Conventional maintenance intervals, which are fixed, do not take into account the behavior of desired operational metrics as a function of unit operation. In some conventional solutions, an elliptical relationship is assumed between number of starts of systems and hours a system is running. In those elliptical solutions, units are often recommended to be serviced prematurely for part of the operational profile spectrum and conversely are recommended to be serviced later than the appropriate interval.

There is a long felt and unsolved need for enhanced systems and methods to accurately assess the correct operational period for each individual unit within a fleet of units so as to maximize their value and minimize losses due to their being taken off-line unexpectedly.

### BRIEF DESCRIPTION OF INVENTION

A method for determining recommended maintenance intervals for a fleet of units is based on the operational profile of each unit. Each unit in the fleet is run to a constant value of an operational metric regardless of operational profile. For example, operational metrics may include at least a constant likelihood of unplanned maintenance, costs of unplanned maintenance, reliability, availability, or even total lifecycle costs (including unplanned outage costs, repair costs, and fallout costs, etc.). Failure mode and effects analyses (FMEA) may be leveraged to ensure that all known and hypothetical failure modes are properly accounted for.

A method for determining recommended maintenance intervals for a fleet of units is based on each unit in the fleet being run to the same value of an operational metric. As noted above, operational metrics may include a likelihood of unplanned maintenance, costs of unplanned maintenance, reliability of an individual unit, availability of replacement parts or replacement units, and total lifecycle costs for an individual unit or a fleet of units.

Operational metrics may be directly linked to reliability models and/or data at the failure mode level for each component or subsystem of interest.

As part of determining an appropriate operational period, models are created at the failure mode level for each component of interest. Typically, these models would result in the probability of an unplanned maintenance event for a given failure mode as a function of an operational parameter. These models may also include data for the consequences of the failure mode if it occurs, e.g., an event duration or cost of repair, etc.

Models for all of the individual failure modes are combined to result in an operational metric of interest. An operational metric "of interest" is a metric which a business wishes to maintain constant for each unit in the fleet. Examples of an operational metric of interest include, but are not limited to, a likelihood of unplanned maintenance, a cost of unplanned maintenance, reliability of a unit, availability of a unit, and a total lifecycle cost.

Based on the models, the maintenance interval, i.e., the operational period, may be adjusted such that each operational profile results in the same value of the operational metric. For example, a curve may be generated which compares a number of starts with hours in operation for a particular unit or a fleet of units. Such a curve may indicate a maintenance interval for any given hours to starts ratio.

Such a system may be re-evaluated within a boundary embodied in the above-discussed curve. Re-evaluation may be accomplished using a design evaluation tool such as Failure Modes and Effects Analysis (FMEA). Such a re-evaluation may determine if any new, hypothetical failure mode models should be added, given the new expanded boundary for the maintenance interval (relative to conventional methods). If any new failure models are identified, then their corresponding models are added and new models are recreated for all of the individual failure modes as discussed above.

As a result, a recommended operational interval for each unit in a fleet of units is generated based on its individual operating profile, the individual operating profile maintaining the same value of an operating metric across all units in the fleet.

Regarding reliability, empirical data of actual wear, degradation, and damage occurring in the machine may be used to enhance the modeling of machine failure modes. The model may be used to calculate the reliability of the machine and determine an optimal period between off-line maintenance and repair sessions. The model combines data from historical field failures and potential, also referred to as unforeseen, failures based on monitoring the machine, such as by boroscopic inspections.

Reliability data may come in different forms, each of which may require a different tool to measure, capture, and/or collect. Reliability data may include at least: A) Operational data, which may be automatically collected from each unit and/or may be transmitted to a central monitoring system; B) Cost data, which may be related to unplanned downtime and may be captured in a financial accounting system; and C) Field engineering reports, which may describe failure modes, including those that have occurred in the past. These examples are illustrative and non-limiting.

Reliability data may be recorded on a variety of storage devices, which may function as intermediate storage devices prior to the data being consolidated into a final storage device. The intermediate and/or consolidated data may be used to create reliability models at the failure mode level. Storage devices may include at least: A)a first database system which may be used to store operational data automatically collected from each unit and/or transmitted to a central monitoring system; B) a second database system which may be used to store financial accounting data; C) a server which may be used to store field reports that may have been created using conventional office software programs, such as word processing programs, and the reports may be created and/or stored as individual files; and D) a third database system may store reliability data compiled from multiple databases and/or storage devices. The databases may be intermediate databases. These examples are illustrative and non-limiting.

Analysis devices may be used to create models of data which has been collected regarding units within a fleet and/or the fleet as a whole. The analysis devices may be used to create models at the failure mode level for each component of interest from the reliability data. After models have been created, one or more analysis devices may be used to apply the created model(s) to predict future reliability, availability, unplanned cost, and other operational considerations. One or more analysis devices may also be used to evaluate those models in order to calculate a recommended fleet maintenance interval. For example, analysis devices may include at least: A) statistical analysis software used by a reliability engineer to iteratively create models at the failure mode level for each component of interest; B) spreadsheet-based software tools; C) stochastic simulation software; and D) personal computer, server, or cloud-based simulation software. These examples are illustrative and non-limiting.

A power generation unit may include a gas turbine, a steam turbine, or another power generation device.

### BRIEF DESCRIPTION OF THE DRAWINGS

FIG. 1 illustrates a process flow chart mapping steps for determining a recommended maintenance interval;
FIG. 2 illustrates a graphical representation of a comparison of conventional maintenance intervals compared with recommended maintenance intervals according to the application;
FIG. 3 illustrates an alternate graphical representation of a comparison of conventional maintenance intervals compared with recommended maintenance intervals according to the application;
FIG. 4(a) illustrates a graphical representation of an operating metric as a function of an operational profile according to conventional means;
FIG. 4(b) illustrates an alternate graphical representation of an operating metric as a function of an operational profile related to the graphical representation illustrated in Fig. 2.
FIG. 4(c) illustrates yet another alternate graphical representation of an operating metric as a function of an operational profile related to the graphical representation illustrated in Fig. 3.
FIG. 5 illustrates a combined graphical representation illustrating a curve of Fig. 4(b) alongside a curve of Fig. 4(c).

### DETAILED DESCRIPTION OF THE INVENTION

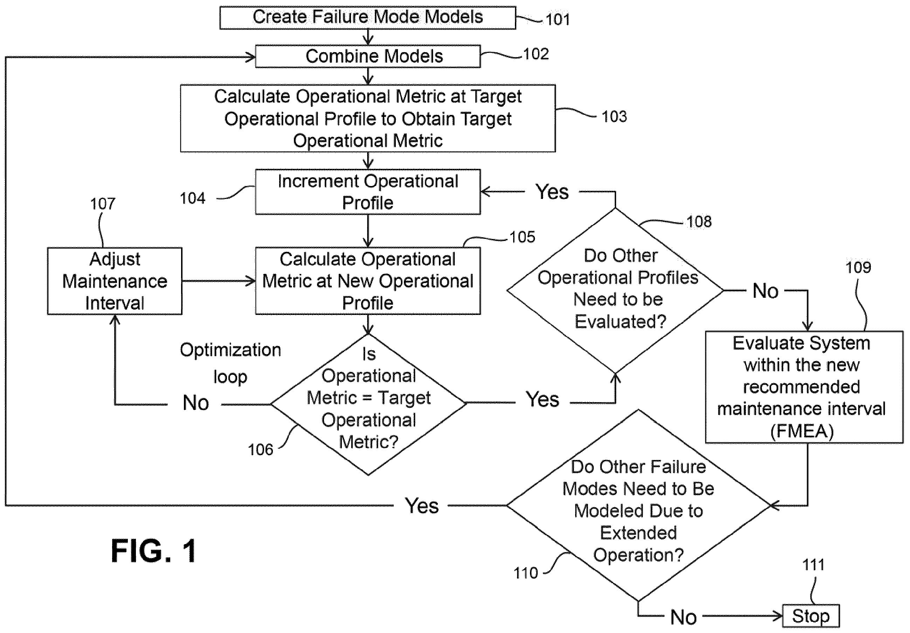

FIG. 1 illustrates a process flow chart mapping steps for determining a recommended maintenance interval. As a first step 101, failure mode models are created. In step 101, models are created for each component of interest. The various failure mode models are then combined in step 102 to create a mathematical model, optionally illustrated as a graphical representation, of a particular operational metric of interest. After combining the various failure mode models generated in step 102, a target operational metric is obtained in step 103 by calculating an operational metric at a target operational profile.

With the target operational metric obtained in step 103, the operational profile may then be incremented in step 104. In the incrementation of step 104, the maintenance interval may be adjusted such that each operational profile results in the same value of the operational metric. After the incrementation of step 104, an operational metric may be calculated at the new operational profile in step 105. After the new operational metric is calculated in step 105, the operational metric is compared with a target operational metric in step 106. If the operational metric calculated in step 105 is not equal to a target operational metric, the system may enter an optimization loop, whereby the maintenance interval is adjusted in step 107 followed by a new calculation of an operational metric at the newest operational profile in step 105.

If, on the other hand, the operational metric is found to be equal, within a desired tolerance (for example, +/- 0.1 %), to the target operational metric in step 106, the system may then consider whether other operational profiles need to be evaluated as part of the process of determining maintenance intervals in step 108. If the system or an operator of the system determines that other operational profiles need to be evaluated, the operational profile may again be incremented as in step 104. If the operational profile is again incremented in step 104, a new operational metric is again calculated at the newest operational profile in step 105, followed by the comparison in step 106.

If, on the other hand, it is determined that no other operational profiles need to be evaluated in step 108, the system may then be evaluated within a new recommended maintenance interval using, e.g., FMEA procedures, in step 109.

After an evaluation of the system in step 109, the system or an operator of the system determines whether any other failure modes need to be modeled due to extended operation in step 110. If step 110 determines that yes, additional failure modes need to be modeled, the new additional models are combined with all the other models already considered in step 102. The system then proceeds through the steps outlined above with the new additional model(s) combined in step 102. If, however, step 110 determines that no other failure modes need to be modeled or considered, the system is completed and a maintenance interval is determined in step 111.

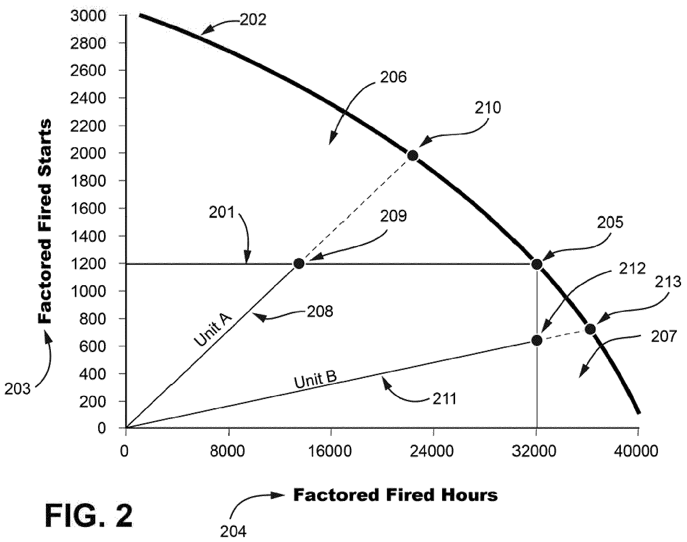

FIG. 2 illustrates a graphical comparison between conventional maintenance periods in curve 201 and a curve 202 based on the operational metric of the present application. In this figure, the vertical axis comprises a measure of factored fired starts 203 for a power generation unit. The horizontal axis comprises a measure of factored fired hours 204 for the power generation unit. Curve 202 is illustrated as an iso-value curve for an operational metric. In this particular example, the operational metric is set equal to the value of the operational metric of the prior art (conventional) hours and starts maintenance interval, as indicated at point 205.

Line 208 illustrates an example "unit A" being considered for when to take unit A offline for scheduled maintenance. Point 209 illustrates the conventional point at which unit A would be taken offline, while point 210 illustrates a point according to the present technology when unit A would be taken offline. According to conventional methods, as soon as unit A had been started 1200 times, the unit must be taken offline, regardless of how many hours the unit had actually been in operation.

Line 211 illustrates another example "unit B" being considered for when to take unit B offline for scheduled maintenance. According to conventional methods, as soon as unit B reached 32000 hours in service, regardless of the number of fired starts, unit B would be taken offline. Similarly, point 212 illustrates a point at which unit B would be taken offline for maintenance according to conventional methods, while point 213 illustrates a point according to the present technology when unit B would be taken offline.

As illustrated in Figure 2, the area 206, 207 between curve 201 and curve 202 represents additional unit operation that becomes possible using the system described herein. The dashed section of line 208 illustrates the added operational time of unit A as a result of the present technology. The dashed section of line 211 illustrates the additional operational time of unit B as a result of the present technology.

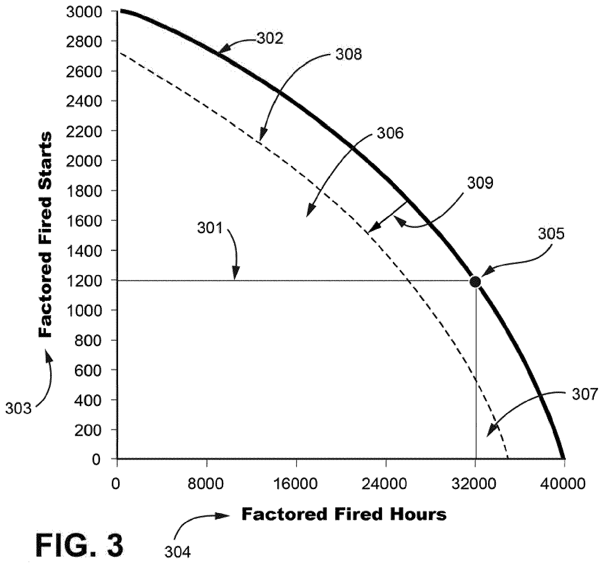

FIG. 3 illustrates a graphical comparison between conventional maintenance periods in curve 301 and a curve 302 based on the operational metric of the present application, similar to the curves illustrated in Figure 2. In Figure 3, the vertical axis comprises a measure of factored fired starts 303 for a power generation unit. The horizontal axis comprises a measure of factored fired hours 304 for the power generation unit. Figure 3 also illustrates a third curve 308, which is also an iso-value curve for the operational metric, but with the operational metric set to a value below the operational metric that resulted in curve 302. As indicated by arrow 309, setting the operational metric to a lower value shifts the curve representing an improved maintenance interval determined herein by the present application. For example, curve 302 may represent an operational metric set to a likelihood of an unplanned outage or failure at approximately 30%, while curve 308 may represent a likelihood of an unplanned outage or failure at approximately 25%, which represents a lowered likelihood that a unit in a fleet of units will experience a failure.

Similar to Fig. 2, area 306, 307 represents additional unit operation that becomes possible relative to the conventional maintenance interval determination. Due to the shift in curve 308, area 306, 307 is smaller than area 206, 207 illustrated in Figure 2. Curve 308 represents a recommended maintenance interval for the fleet with a reduced likelihood of failure as compared to Curve 302.

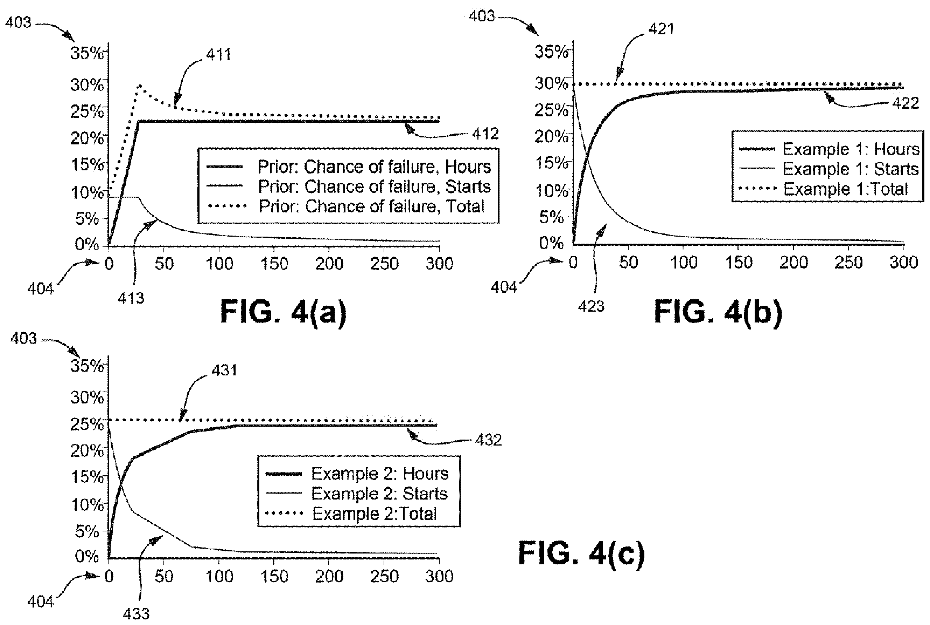

FIG. 4(a) illustrates a graph of an operating metric as a function of an operational profile according to prior art. Here, as an exemplary operating metric, the "likelihood of unplanned outage" is used. The exemplary operating profile comprises an "N ratio" defined as Factored Fired Hours/Factored Starts. Other operating metrics or operating profiles may be used. Fig. 4(a) has a vertical axis 403 comprising Y, an operating metric. In Fig. 4(a), the operating metric is illustrated as a likelihood of an unplanned outage, expressed as a percentage probability. Fig. 4(a) also has a horizontal axis 404 comprising X, an operational profile. The operational profile is illustrated as the N ratio defined above as Factored Fired Hours/Factored Starts. Curve 412 illustrates an example likelihood of an unplanned outage due to failure modes dependent on the number of hours a power generation unit has been in operation. Curve 413 illustrates an example likelihood of an unplanned outage due to failure modes dependent on the number of factored starts for a power generation unit. Curve 411 is a combined curve illustrating a total probability of an unplanned outage as a function of the operational profile.

FIG. 4(b) illustrates a graph of an operating metric as a function of an operational profile according to the operating profile illustrated in Fig. 2. Here, as in Fig. 4(a), as an exemplary operating metric, the "likelihood of unplanned outage" is used. The exemplary operating profile comprises an "N ratio" defined as Factored Fired Hours/Factored Starts. Other operating metrics or operating profiles may be used. Fig. 4(b) has a vertical axis 403 comprising Y, an operating metric. In Fig. 4(b), the operating metric is illustrated as a likelihood of an unplanned outage, expressed as a percentage probability. Fig. 4(b) also has a horizontal axis 404 comprising X, an operational profile. The operational profile is illustrated as the N ratio defined above as Factored Fired Hours/Factored Starts. Curve 422 illustrates an example likelihood of an unplanned outage due to failure modes dependent on the number of factored fired hours a power generation unit has been in operation. Curve 423 illustrates an example likelihood of an unplanned outage due to failure modes dependent on the number of factored starts for a power generation unit. Curve 421 is a combined curve illustrating a total likelihood of an unplanned outage as a function of the operational profile.

FIG. 4(c) illustrates a graph of an operating metric as a function of an operational profile according to the operating profile illustrated in Fig. 3. Here, as in Fig. 4(a), as an exemplary operating metric, the "likelihood of unplanned outage" is used. The exemplary operating profile comprises an "N ratio" defined as Factored Fired Hours/Factored Starts. Other operating metrics or operating profiles may be used. Fig. 4(c) has a vertical axis 403 comprising Y, an operating metric. In Fig. 4(c), the operating metric is illustrated as a likelihood of an unplanned outage, expressed as a percentage probability. Fig. 4(c) also has a horizontal axis 404 comprising X, an operational profile. The operational profile is illustrated as the N ratio defined above as Factored Fired Hours/Factored Starts. Curve 432 illustrates an example likelihood of an unplanned outage due to failure modes dependent on the number of factored fired hours a power generation unit has been in operation. Curve 433 illustrates an example likelihood of an unplanned outage dependent on the number of factored starts for a power generation unit. Curve 431 is a combined curve illustrating a total likelihood of an unplanned outage as a function of the operational profile.

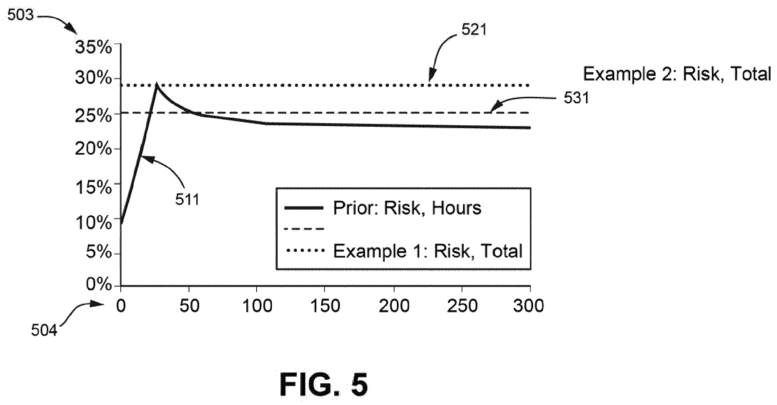

FIG. 5 illustrates a graph of an operating metric as a function of an operational profile according to the operating profiles illustrated in Figs. 2-3. Here, as in Fig. 4(a), as an exemplary operating metric, the "likelihood of unplanned outage" is used. The exemplary operating profile comprises an "N ratio" defined as Factored Fired Hours/Factored Starts. Other operating metrics or operating profiles may be used. Fig. 5 has a vertical axis 503 comprising Y, an operating metric. In Fig. 5, the operating metric is illustrated as a likelihood of an unplanned outage, expressed as a percentage probability. Fig. 5 also has a horizontal axis 504 comprising X, an operational profile. The operational profile is illustrated as the N ratio, defined above as Factored Fired Hours/Factored Starts.

Fig. 5 juxtaposes total likelihood of an unplanned outage according to the prior art in curve 511, according to the maintenance interval illustrated as line 202 in Fig. 2 in curve 521 of Figure 5, and according to the maintenance interval illustrated as line 308 in Fig. 3 in curve 531 of Figure 5.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the spirit and scope of the appended claims.

Various aspects and embodiments of the present invention are defined by the following numbered clauses:
1. A method for determining a recommended maintenance interval for each of a plurality of units within a fleet of power generation units, comprising:
   collecting operational and unplanned maintenance data for a plurality of units within a fleet of power generation units;
   evaluating the operational and unplanned maintenance data;
   generating a plurality of failure mode models based on the empirical data;
   combining the plurality of failure mode models;
   establishing a target operational metric for the combination of the plurality of failure mode models;
   generating a fleet recommended maintenance interval for the fleet of power generation units based on the target operational metric;
   calculating an operational profile for each of the plurality of units within the fleet of power generation units;
   calculating the recommended maintenance interval for each of the plurality of units within the fleet of power generation units based on the operational profile of each unit.
2. The method for determining the recommended maintenance interval according to clause 1, wherein the fleet of power generation units is re-evaluated within the new recommended maintenance interval.
3. The method for determining the recommended maintenance interval according to clause 1, wherein the chosen operational metric is one of: a likelihood of unplanned maintenance, a cost of unplanned maintenance, a reliability, an availability, or a total lifecycle cost.
4. The method for determining the recommended maintenance interval according to clause 1, wherein the chosen operational metric is directly linked to reliability models and data at the failure mode level for one or more subsystems of interest for each unit.
5. The method for determining the recommended maintenance interval according to clause 2, wherein an evaluation is conducted using a design evaluation tool.
6. The method for determining the recommended maintenance interval according to clause 1, wherein the plurality of failure mode models are designed to output a probability of an unplanned maintenance event as a function of an operational parameter.
7. The method for determining the recommended maintenance interval according to clause 1, wherein the plurality of failure mode models include consequence data for consequences of a failure mode if it occurs.
8. The method for determining the recommended maintenance interval according to clause 7, wherein the consequence data includes event duration, event cost, and/or repair cost.
9. The method for determining the recommended maintenance interval according to clause 1, wherein the combination of failure mode models result in an operational metric of interest which a business determining the recommended maintenance interval chooses to maintain constant for each unit in the fleet.
10. The method for determining the recommended maintenance interval according to clause 1, further comprising adjusting the recommended maintenance interval such that each operational profile results in a same value of the chosen operational metric.
11. The method for determining the recommended maintenance interval according to clause 1, wherein the operational profile comprises a curve in a factored starts versus factored hours domain.
12. The method for determining the recommended maintenance interval according to clause 11, wherein the factored starts versus factored fired hours domain defines the maintenance interval for any given hours/starts ratio.
13. The method for determining the recommended maintenance interval according to clause 5, wherein the design evaluation tool comprises Failure Modes and Effects Analysis (FMEA) to determine if any additional failure mode models should be included in the combined plurality of failure mode models;
14. The method for determining the recommended maintenance interval according to clause 1, further comprising determining failure mode models at a component level.
15. A system for determining a recommended maintenance interval for a unit within a fleet of units, comprising:
   the fleet of units;
   at least a first tool configured to measure, collect, and/or capture reliability data of the fleet of units;
   at least a first storage device configured to record the reliability data of the fleet of units; and
   at least a first analysis device configured to evaluate the reliability data of the fleet of units;
   wherein the analysis device is arranged to have an input whereby a user may select an operating metric and the analysis device is configured to generate a recommended service interval based on at least the reliability models and the target operating metric.

## Claims

1. A method for determining a recommended maintenance interval for each of a plurality of units within a fleet of power generation units, comprising:
collecting empirical data representing operational and unplanned maintenance data for a plurality of units (208, 211) within a fleet of power generation units;
evaluating the empirical data of the operational and unplanned maintenance data;
generating (101) a plurality of failure mode models based on the empirical data;
combining (102) the plurality of failure mode models;
establishing (103, 104) a target operational metric for the combination of the plurality of failure mode models;
generating (202, 302) a fleet recommended maintenance interval for the fleet of power generation units based on the target operational metric;
calculating (208) an operational profile for each of the plurality of units within the fleet of power generation units;
calculating (108, 109, 210) the recommended maintenance interval for each of the plurality of units within the fleet of power generation units based on the operational profile of each unit.

2. The method for determining (108, 109) the recommended maintenance interval according to claim 1, wherein the fleet of power generation units is re-evaluated (109) within the new recommended maintenance interval.

3. The method for determining (108, 109) the recommended maintenance interval according to claim 1 or claim 2, wherein the chosen operational metric is one of: a likelihood of unplanned maintenance, a cost of unplanned maintenance, a reliability, an availability, or a total lifecycle cost.

4. The method for determining (108, 109) the recommended maintenance interval according to claim 1, wherein the chosen operational metric is directly linked to reliability models and data at the failure mode level for one or more subsystems of interest for each unit.

5. The method for determining (108, 109) the recommended maintenance interval according to claim 2, wherein an evaluation is conducted using a design evaluation tool.

6. The method for determining (108, 109) the recommended maintenance interval according to claim 1, wherein the plurality of failure mode models are designed to output a probability of an unplanned maintenance event as a function of an operational parameter.

7. The method for determining (108, 109) the recommended maintenance interval according to claim 1, wherein the plurality of failure mode models include consequence data for consequences of a failure mode if it occurs.

8. The method for determining (108, 109) the recommended maintenance interval according to claim 7, wherein the consequence data includes event duration, event cost, and/or repair cost.

9. The method for determining (108, 109) the recommended maintenance interval according to claim 1, wherein the combination of failure mode models result in an operational metric of interest which a business determining the recommended maintenance interval chooses to maintain constant for each unit in the fleet.

10. The method for determining (108, 109) the recommended maintenance interval according to claim 1, further comprising adjusting (107) the recommended maintenance interval such that each operational profile results in a same value of the chosen operational metric.

11. The method for determining (108, 109) the recommended maintenance interval according to claim 1, wherein the operational profile comprises a curve (202) in a factored starts versus factored hours domain.

12. The method for determining (108, 109) the recommended maintenance interval according to claim 11, wherein the factored starts versus factored fired hours domain defines the maintenance interval for any given hours/starts ratio.

13. The method for determining (108, 109) the recommended maintenance interval according to claim 5, wherein the design evaluation tool comprises Failure Modes and Effects Analysis (FMEA) to determine if any additional failure mode models should be included in the combined plurality of failure mode models;

14. The method for determining (108, 109) the recommended maintenance interval according to claim 1, further comprising determining failure mode models at a component level.
